**Europäisches Patentamt**

**European Patent Office**

**Office européen des brevets**

(19)

(11) Veröffentlichungsnummer: **0 214 541**

**A2**

(12) # EUROPÄISCHE PATENTANMELDUNG

(21) Anmeldenummer: **86111712.5**

(51) Int. Cl.⁴: **G 11 C 27/02**

(22) Anmeldetag: **23.08.86**

(30) Priorität: **09.09.85 CH 3876/85**

(43) Veröffentlichungstag der Anmeldung:
**18.03.87 Patentblatt 87/12**

(84) Benannte Vertragsstaaten:
**AT BE CH DE FR GB IT LI NL SE**

(71) Anmelder: **Willi Studer AG, Fabrik für elektronische
Apparate
Althardstrasse 30
CH-8105 Regensdorf ZH(CH)**

(72) Erfinder: **Schmid, Johann Jakob
Rosengartenstrasse 33
CH-8107 Buchs ZH(CH)**

(72) Erfinder: **Thie, Werner
Seidenstrasse 18
CH-8400 Wintherthur(CH)**

(54) **Vorrichtung zur Digitalisierung eines analogen Signales.**

(57) Zur Vereinfachung einer solchen Vorrichtung wird als Bandbegrenzungsfilter (15, 16, 17) und als Abtast-und Halteglied zusammen ein Filter mit Abtastung analoger Eingangswerte, insbesondere ein Filter mit geschalteten Kapazitaeten in intergrierter Bauweise verwendet, dessen Ausgangstreiber ein weiteres Schaltelement mit einer Kapazitaet vorgeschaltet ist.

Fig. 1

EP 0 214 541 A2

Vorrichtung zur Digitalisierung eines analogen Signales

------------------------------------------------------------

Die Erfindung betrifft eine Vorrichtung zur Digitalisierung eines analog anfallenden Signales, mit einem Bandbegrenzungsfilter, einem Abtast- und Halteglied und mit einem Analog/Digital-Wandler.

Allgemein bekannte Vorrichtungen der genannten Art bestehen aus einer Serieschaltung eines Bandbegrenzungsfilters, eines Abtast- und Haltegliedes (Sample and Hold) und eines Analog/-Digital-Wandlers. Dabei sorgt das Bandbegrenzungsfilter dafuer, dass keine hochfrequenten Signalteile durchgelassen werden, deren Frequenz groesser ist als die halbe Abtastfrequenz. Das Abtast- und Halteglied bildet aus dem analogen Signal die einzelnen Abtastwerte und speichert sie fuer die Zeit eines Abtastintervalles. Der Analog/Digital-Wandler quantisiert die einzelnen Abtastwerte gemaess einer gegebenen Regel, so dass sie in der Form eines Datenwortes auftreten.

Der Nachteil der bekannten Vorrichtung besteht darin, dass diese Serieschaltung einen grossen Schaltungsaufwand ergibt und viele einzelne Elemente umfasst. Oft findet die Signalverarbeitung parallel fuer verschiedene Signale auf mehreren Kanaelen statt. Damit vervielfacht sich dementsprechend der Schaltungsaufwand.

Die Erfindung wie sie durch die Ansprueche gekennzeichnet ist, loest die Aufgabe eine Vorrichtung zu schaffen, deren Aufbau im Vergleich zu bekannten Vorrichtungen vereinfacht ist, ohne deren Funktionsweise zu beeintraechtigen.

Die durch die Erfindung erreichten Vorteile sind insbesondere darin zu sehen, dass ein Abtast- und Halteglied wie es ueblicherweise einem Analog/Digital-Wandler vorgeschaltet ist, eingespart werden kann. Das Filter und das Abtast- und Halteglied werden zusammen unter Verwendung derselben Elemente integriert, so dass kein eigenstaendiges Abtast- und Halteglied mehr auftritt. Der Ausgangstreiber des Filters wird durch Zufuegen eines Schalters und eines Kondensators wie er im Filter verwendet wird, zu einem Abtast- und Halteglied umgebaut. Bei den gemaess der Erfindung vorgeschlagenen Filtern kann zudem die Filterfunktion zusaetzlich veraendert und durch einen Rechner angepasst werden und zwar auch laufend, durch die Ausgabe eines Signales durch den Rechner. Die Filterfunktion kann in einem gewissen Bereiche veraendert werden, ohne dass Bestandteile des Filters ausgewechselt werden muessen. So kann die Signalverarbeitung laufend optimal an die eintreffenden Signale angepasst werden.

Im folgenden wird die Erfindung anhand von lediglich einen Ausfuehrungsweg darstellenden Zeichnungen naeher erlaeutert. Es zeigt

Figur 1 ein Blockschema der erfindungsgemaessen Vorrichtung,

Figur 2a und 2b je ein einfaches Beispiel fuer ein Bandbegrenzungsfilter und

Figur 3 eine schematische Darstellung eines Teils der Vorrichtung.

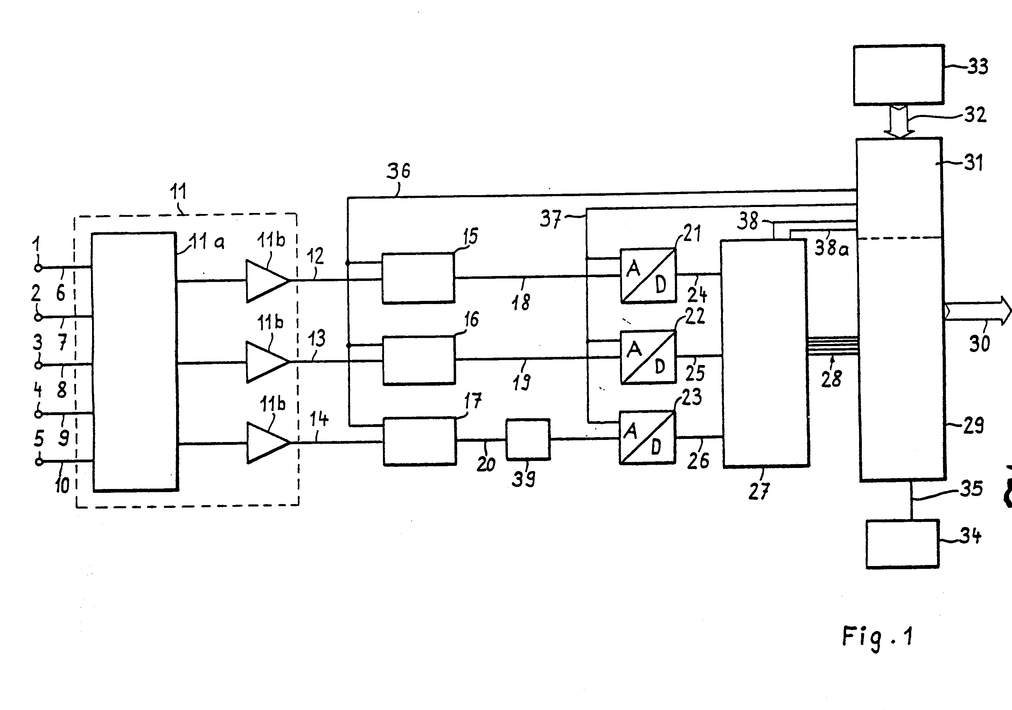

Das Blockschema wie es Figur 1 zeigt, ist fuer eine Vorrichtung gedacht, die zur Verarbeitung von physiologischen Messsignalen, wie sie beispielsweise in der Umgebung des Herzens eines Lebewesens abgegriffen werden koennen, ausgelegt ist. Deshalb sind Elektroden 1, 2, 3, 4 und 5 ueber Leitungen 6, 7, 8, 9 und 10 an eine Eingangsverstaerkergruppe 11 angeschlossen. Solche Eingangsverstaerkergruppen sind an sich bekannt und dienen der Bildung von sogenannten Ableitungen oder Differenzen zwischen den Signalen aus je zwei Elektroden. Die Eingangsverstaerkergruppe 11 besteht aus einer Signaldifferenzbildungsschaltung 11a und aus daran angeschlossenen Verstaerkern 11b. Leitungen 12, 13 und 14 verbinden die Eingangsverstaerkergruppe 11 mit je einem Bandbegrenzungsfilter 15, 16 und 17. Ueber Leitungen 18, 19 und 20 sind die Bandbegrenzungsfilter 15, 16 und 17 an je einen Analog/Digital-Wandler 21, 22 und 23 angeschlossen. Leitungen 24, 25 und 26 verbinden diese wiederum mit einem Multiplexer 27, der seinerseits ueber Leitungen 28 an einen Rechner 29 angeschlossen ist. Als Ausgang weist der Rechner 29 einen Bus 30 auf. Als Taktsignalquelle ist eine Zeitsteuerung 31 vorgesehen. Sie kann als Teil des Rechners 29 aufgefasst werden. Ueber einen Bus 32 ist der Rechner 29 mit einer Eingabeeinheit 33 verbunden. Ferner ist ein Quarz 34 ueber eine Leitung 35 an den Rechner 29 angeschlossen. Zur Uebertragung von Taktsignalen von der Zeitsteuerung 31 an die Bandbegrenzungsfilter 15, 16 und 17, an die Analog/Digital-Wandler 21, 22 und 23 sowie an den Multiplexer 27, sind Leitungen 36, 37, 38 und 38a vorgesehen. Wahlweise kann auch je ein Hochpassfilter 39 zwischen die Bandbegrenzungsfilter 15, 16, 17 und die Analog/Digital-Wandler 21, 22, 23 eingeschaltet sein. Es dient zur Ausschaltung eines Gleichspannungsanteiles der Signale.

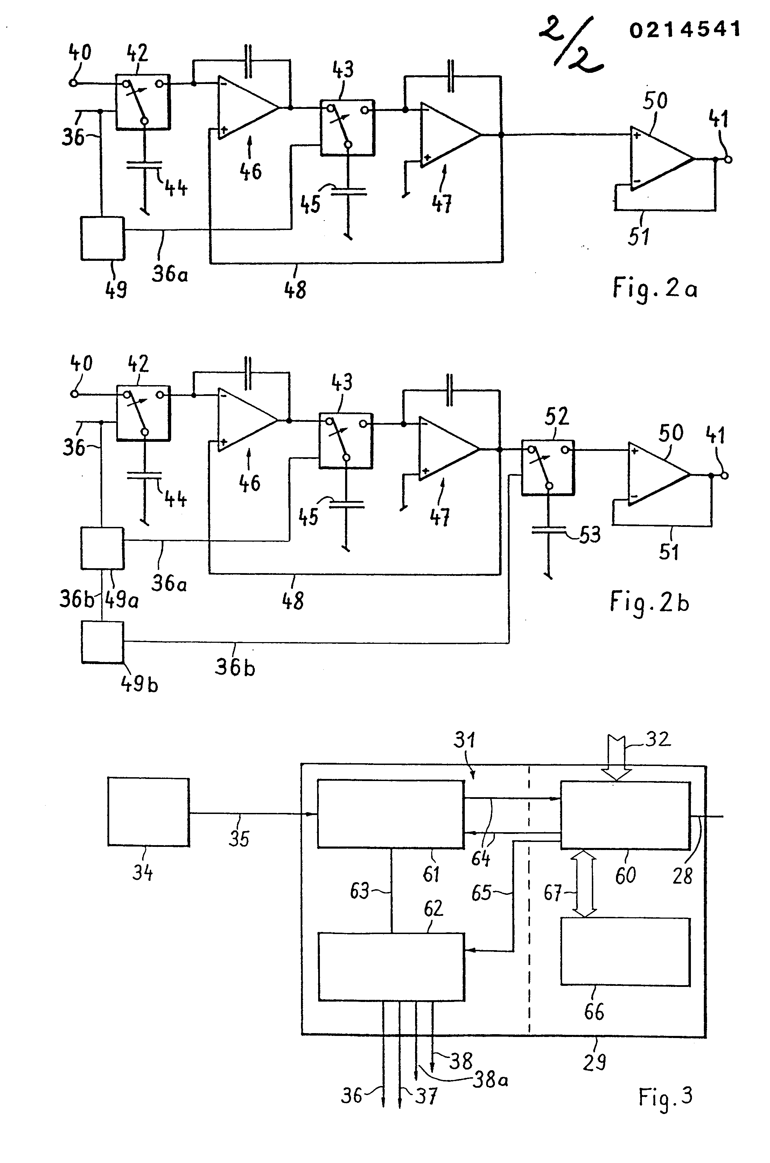

Figur 2a zeigt ein Beispiel eines Filters mit Abtastung analoger Eingangswerte gemaess dem Stand der Technik. Es ist als an sich bekanntes SC-Filter zweiter Ordnung mit Tiefpasscharakteristik ausgebildet. Es weist je einen Eingang 40 und einen Ausgang 41 sowie ueber Schalter 42 und 43 geschaltete Kondensatoren 44 und 45 auf. Vorzugsweise sind die Schalter 42 und 43 in Halbleitertechnik realisiert. Den Schaltern 42 und 43 nachgeschaltet ist je ein Integrator 46 und 47, die zudem ueber eine Rueckkopplung 48 miteinander verbunden sind. Den Integratoren 46 und 47 ist ein Operationsverstaerker 50 mit einer Rueckkopplung 51 auf seinen invertierenden Eingang nachgeschaltet, der dazu dient, die Signale des letzten Integrators 47 soweit zu verstaerken, dass sie fuer die nachfolgende Signalverarbeitung nutzbar sind. Dieser Operationsverstaerker 50 mit seiner Rueckkopplung 51 hat die Funktion eines Puffers, wie er in solchen Filtern in integrierter Bauweise allgemein vorgesehen ist und auch als Ausgangstreiber bezeichnet wird. Der Schalter 42 ist an die Leitung 36 angeschlossen. Der Schalter 43 ist ueber ein Verzoegerungsglied 49 und eine Leitung 36a an die Leitung 36 angeschlossen. Das Verzoegerungsglied 49 bewirkt eine Verzoegerung der Taktsignale aus Leitung 36 um einen Bruchteil einer Taktperiode.

Figur 2b zeigt im wesentlichen genau das gleiche Filter mit Abtastung analoger Eingangswerte mit zwei Filterstufen 42, 44, 46 und 43, 45, 47 wie es die Figur 2a zeigt. Es ist aber gemaess der Erfindung angepasst und in integrierter Bauweise ausgefuehrt. Dem Operationsverstaerker 50 ist demnach noch ein Schaltelement 52 mit einem Kondensator 53 als Kapazitaet vorgeschaltet. Das Schaltelement 52 und die Kapazitaet 53 sind mit den Schaltern 42 und 43 und deren Kondensatoren 44 und 45 der Filterstufen identisch ausgebildet. Das Schaltelement 52 ist auch ueber Leitungen 36b und eventuell auch eine weitere Verzoegerungseinheit 49b an die Leitung 36 angeschlossen, die ihm die Taktfrequenz liefert. Das Schaltelement 52 kann auch direkt an die Leitung 36a oder an die Leitung 37 angeschlossen sein.

Figur 3 zeigt nochmals schematisch den Quarz 34 der ueber eine Leitung 35 an den Rechner 29 angeschlossen ist. Der Rechner 29 weist dabei neben einem Mikroprozessor 60 einen Generator 61 und einen Frequenzteiler 62 auf. Leitungen 36, 37, 38 und 38a bilden Ausgaenge aus dem Frequenzteiler 62. Der Generator 61 und der Frequenzteiler 62 bilden zusammen die Zeitsteuerung oder Taktfrequenzquelle 31. Dabei ist der Generator 61 ueber eine Leitung 63 mit dem Frequenzteiler 62 und ueber weitere Leitungen 64 mit dem Mikroprozessor 60 verbunden. Eine Leitung 65 verbindet diesen mit dem Frequenzteiler 62. Der Bus 32 ist an den Mikroprozessor 60 angeschlossen. Der Mikroprozessor 60 ist ferner ueber einen Bus 67 mit einem Speicher 66 verbunden, der vorzugsweise als RAM ausgebildet ist. Ebenso ist der Mikroprozessor 60 an die Leitung 28 angeschlossen, so dass ihm alle Abtastwerte zugefuehrt werden koennen.

Der Quarz 34 gibt ueber die Leitung 35 eine sehr hochfrequente Schwingung im Megahertzbereich an den Generator 61 ab.

Dieser formt diese sinusfoermige Schwingung in eine Folge von Rechteckimpulsen um, die ueber die Leitung 63 dem Frequenzteiler 62 zugefuehrt werden. Die Frequenz der Schwingung in der Leitung 63 kann durch den Frequenzteiler 62 mit Faktoren $2^l$ oder $2^i$ geteilt werden. Dabei gilt $2^l = k \cdot 2^i$. k kann beliebige ganze Zahlen annehmen. Die durch $2^i$ geteilte Frequenz wird ueber die Leitung 36 abgegeben. Die durch $2^l$ geteilte Frequenz wird ueber die Leitung 37 abgegeben. Dabei unterscheiden sich die Frequenzen der Taktsignale in den Leitungen 36 und 37 um den Faktor k. Ueber die Leitungen 38 und 38a koennen noch weitere Taktsignale mit anderen Frequenzen abgegeben werden. Ueber die Leitung 65 kann der Mikroprozessor 60 die Werte fuer die Faktoren k, l und i an den Frequenzteiler 62 abgeben. Ueber die Leitungen 64 gibt der Generator 61 auch Taktsignale an den Mikroprozessor 60 ab, der diese fuer seine Arbeit braucht. Ebenso empfaengt der Generator 61 ueber diese Leitung 64 Start- und Stopsignale.

Die Elektroden 1, 2, 3, 4 und 5 liefern analoge Signale zum Beispiel in der Form elektrischer Spannungen. In der Signaldifferenzbildungsschaltung 11a werden aus den Signalen von je zwei der Leitungen 6, 7, 8, 9 oder 10 Signaldifferenzen gebildet, die anschliessend in den Verstaerkern 11b verstaerkt werden. Dies ergibt in den Leitungen 12, 13 und 14 analoge Signale, welche in den Bandpassfiltern 15, 16 und 17 von allfaelligen hochfrequenten Signalteilen befreit werden, um spaeter deren Rueckfaltung in den Frequenzbereich der tieferfrequenten Nutzsignale zu vermeiden, wie dies bei der Digitalisierung von Signalen unter der Bezeichnung "Aliasing" bekannt ist. Solche Bandbegrenzungsfilter lassen sich als passive Filter (bestehend aus Widerstaenden, Kapazitaeten und Induktivitaeten) aber auch als aktive Filter (mit Operationsverstaerkern statt Induktivitaeten) ausbilden. Besonders guenstig ist es aber solche Bandbegrenzungsfilter als Filter mit Abtastung analoger Eingangswerte auszubilden. Bei diesen Filtern werden die analog anfallenden Eingangswerte zuerst mit einer bestimmten Abtastfrequenz abgetastet. Die so gewonnenen Abtastwerte werden dann so weiter verarbeitet, dass die gewuenschte Filterfunktion fuer die integrierten Ausgangsabtastwerte des Filters erfuellt ist. Ein Beispiel solcher Filter sind die Filter mit geschalteten Kapazitaeten (auch als SC-Filter bekannt). Bei diesen sind die Widerstaende durch Kapazitaeten ersetzt, die durch Schaltelemente zu- und weggeschaltet werden koennen. Als Beispiel eines solchen Filters sei der Typ MF6CN der Firma National Semiconductors genannt.

Gemaess der Erfindung kann beim Einsatz solcher integrierter Filter als Bandbegrenzungsfilter in der genannten Vorrichtung auf die Verwendung von eigenstaendigen, dem Filter nachgeschalteten Abtast- und Haltegliedern verzichtet werden. Dies weil die Arbeitsweise solcher Filter darin besteht, das eintreffende analoge Signal in eine Folge von Abtastwerten zu zerlegen. Dies allerdings mit einer Frequenz, die nicht der fuer die Vorrichtung gewuenschten Abtastfrequenz entspricht, sondern durch den Frequenzgang bestimmt wird, den das Filter aufweisen soll. Um am Ausgang 41 Abtastwerte mit der Abtastfrequenz fuer die Analog/Digital-Wandler oder mit einem Vielfachen dieser Abtastfrequenz zu erhalten, muss das Schaltelement 52 (Fig. 2b) mit einer entsprechenden Frequenz angesteuert werden. Diese Frequenz kann ein Vielfaches der Abtastfrequenz betragen, darf aber die Filterfrequenz nicht uebersteigen. Der nachgeschaltete Analog/Digital-Wandler nimmt dann nur noch Werte mit der Abtastfrequenz auf, auch wenn Werte mit hoeherer Frequenz anfallen.

Solche Bandbegrenzungsfilter sind ueblicherweise als Tiefpassfilter ausgelegt. Ab einer oberen Grenzfrequenz sperren sie den Durchgang fuer Signale oder Signalteile mit einer hoeheren Frequenz. Gemaess dem Sampling Theorem von Shannon muss die Abtastfrequenz fuer die Digitalisierung solcher Signale mindestens doppelt so hoch sein wie diese obere Grenzfrequenz. Fuer das genannte Filter des Typs MF6CN liegt aber die Frequenz, mit der die analogen Eingangswerte abgetastet werden, mindestens fuenfzig mal hoeher als die obere Grenzfrequenz des Filters oder mindestens fuenfundzwanzig mal hoeher als die Abtastfrequenz, die fuer die Digitalisierung erwuenscht ist.

Die ganze Vorrichtung gemaess Figur 1 wird durch Taktsignale aus dem Quarz 34 gesteuert. Die Zeitsteuerung 31 kann aus diesen Taktsignalen fuer die einzelnen Elemente andere Taktsignale ableiten deren Frequenz in einem festen Verhaeltnis zu den Taktsignalen aus dem Quarz 34 stehen. Ein hochfrequentes Taktsignal wird beispielsweise ueber Leitung 36 den Bandbegrenzungsfiltern 15, 16 und 17 zugeleitet. Durch dieses Taktsignal werden die Schaltelemente 42, 43 in den SC-Filtern (Fig. 2) betaetigt und damit die Kondensatoren 44, 45 periodisch aufgeladen und wieder entladen. Dies geschehe beispielsweise mit einer Frequenz von 12,5 kHz. So entstehen Abtastwerte, die im Operationsverstaerker 47, der als Integrator arbeitet, wieder integriert werden. Im Schaltelement 52 wird dieses Signal wieder abgetastet und im Operationsverstaerker 50 so verstaerkt, dass fuer die nachfolgende Signalverarbeitung brauchbare Abtastwerte zur Verfuegung stehen.

Diese Abtastwerte werden ueber Leitung 18, 19 oder 20 je einem Analog/Digital-Wandler zugefuehrt. Dieser erhaelt Taktsignale aus der Leitung 37, deren Frequenz geringer ist als diejenige der Taktsignale in Leitung 36 oder 36b. Fuer unser Beispiel betraegt die Frequenz fuer diese Taktsignale mindestens 500 Hz. Das entspricht mindestens der gewuenschten Abtastfrequenz. Das bewirkt moeglicherweise, dass der Analog-/Digital-Wandler 21, 22 oder 23 aus mehreren aufeinanderfolgenden Abtastwerten nur einen aufnimmt. Zum Beispiel jeden fuenfundzwanzigsten. Die anderen Abtastwerte werden gar nie eingelesen. So arbeiten die Analog/Digital-Wandler 21, 22 und 23 nur noch mit der Abtastfrequenz des gewuenschten digitalisierten Signales.

Der Multiplexer 27 sammelt die digitalisierten Abtastwerte, die nun durch Datenwoerter einer bestimmten Wortlaenge ausgedrueckt sind und fuehrt sie dem Rechner 29 zu. Dieser ist beispielsweise in der Lage aus diesen Abtastwerten einen

raeumlichen Signalverlauf zu berechnen. Der Multiplexer 27 wird in bekannter Weise durch Taktsignale aus den Leitungen 38 und 38a angesteuert. Diese Taktsignale weisen aber wiederum eine hoehere Frequenz auf. Vorzugsweise entspricht die Taktfrequenz in Leitung 38 der Abtastfrequenz multipliziert mit der Anzahl der Leitungen, die der Multiplexer 27 als Eingaenge hat. Die Taktfrequenz in der Leitung 38a unterscheidet sich um einen Faktor 2/3 von der Taktfrequenz in der Leitung 38, fuer drei Leitungen, die in den Multiplexer 27 muenden. Mit den beiden Taktsignalen aus den Leitungen 38 und 38a kann der Multiplexer 27 seine Arbeit in bekannter Weise ausfuehren.

Zur Ausfuehrung einer solchen Vorrichtung koennen Bauteile des Typs 63B03 fuer den Rechner 29, des Typs ADC1001 fuer die Analog/Digital-Wandler 21, 22 und 23, des Typs CD 4051 fuer den Multiplexer 27, des Typs TL064 fuer die Signaldifferenzbildungsschaltung 11a und des Typs TL064 fuer die Verstaerker 11b verwendet werden.

00 Patentansprueche:

1. Vorrichtung zur Digitalisierung eines analog anfallenden Signales, mit einem Bandbegrenzungsfilter (15, 26, 17), einem Abtast- und Halteglied und einem Analog/Digital-Wandler (21, 22, 23), dadurch gekennzeichnet, dass als Bandbegrenzungsfilter und als Abtast- und Halteglied zusammen, ein Filter mit Abtastung analoger Eingangswerte in integrierter Bauweise vorgesehen ist, das mindestens eine Filterstufe (42, 44, 46) und einen Ausgangstreiber (50, 51) aufweist, wobei dem Ausgangstreiber ein weiteres Schaltelement (52) und eine Kapazitaet (53) vorgeschaltet ist, die aus denselben Elementen bestehen wie die Filterstufe.

2. Vorrichtung gemaess Anspruch 1, dadurch gekennzeichnet, dass als Filter ein Filter mit geschalteten Kondensatoren (44, 45) vorgesehen ist.

3. Vorrichtung gemaess Anspruch 1, wobei dem Analog/Digital-Wandler (21, 22, 23) ein Rechner (29) nachgeschaltet ist, dadurch gekennzeichnet, dass das Filter ueber eine Leitung (36) an den Rechner (29) angeschlossen ist, zur Uebermittlung von Taktsignalen vom Rechner (29) an das Filter.

4. Vorrichtung gemaess Anspruch 1, gekennzeichnet durch deren Verwendung zur Digitalisierung von physiologischen Messsignalen die von einem Lebewesen abgegriffen werden.

5. Vorrichtung gemaess Anspruch 1, dadurch gekennzeichnet, dass das Filter an eine Taktsignalquelle (31) angeschlossen ist.

6. Vorrichtung gemaess Anspruch 1, dadurch gekennzeichnet, dass das dem Ausgangstreiber (50, 51) vorgeschaltete Schaltelement (52) eine Schaltfrequenz aufweist, die dem Einfachen oder einem Vielfachen der Abtastfrequenz fuer den Analog/Digital-Wandler (21, 22, 23) besteht.

7. Vorrichtung gemaess Anspruch 6, dadurch gekennzeichnet, dass die Schaltfrequenz des Schaltelementes (52) kleiner ist als die Filterfrequenz.

8. Vorrichtung gemaess Anspruch 1, dadurch gekennzeichnet, dass der Ausgangstreiber (50, 51) des Filters und das weitere Schaltelement (52) mit der Kapazitaet (53) als Abtast- und Halteglied arbeitet.

Fig.1

0214541

1/2

Fig. 2a

Fig. 2b

Fig. 3